Europäisches Patentamt

European Patent Office

Office européen des brevets

(11) Publication number: **0 031 986**
**A1**

(12) # EUROPEAN PATENT APPLICATION

(21) Application number: **80300051.2**

(22) Date of filing: **04.01.80**

(51) Int. Cl.³: **H 02 M 1/18**
**H 02 H 7/122**

(43) Date of publication of application:
**15.07.81 Bulletin 81 28**

(84) Designated Contracting States:
**DE FR GB**

(71) Applicant: **FUJITSU FANUC LIMITED**
**5-1, Asahigaoka, 3-chome**
**Hino-shi, Tokyo 191(JP)**

(72) Inventor: **Imazeki, Ryoji**
**987-44, Naganuma-cho**
**Hachioji-shi Tokyo(JP)**

(72) Inventor: **Hattori, Masayuki**
**1271-41, Narahara-cho**
**Hachioji-shi Tokyo(JP)**

(72) Inventor: **Nakamura, Shigeo**
**5540, Hino**
**Hino-shi Tokyo(JP)**

(74) Representative: **Overbury, Richard Douglas et al,**
**HASELTINE LAKE & CO Hazlitt House 28 Southampton**
**Buildings Chancery Lane**
**London WC2A 1AT(GB)**

(54) Overcurrent protection apparatus.

(57) Overcurrent protection apparatus in a switching power supply, including a power switching element (6) for interrupting the primary current of a transformer (T), and a control circuit (2, 4, 5) for generating control pulses (Pct) which are modulated in pulse width in accordance with a variation in the rectified output voltage (Vo) on the secondary side of the transformer (T), the opening and closing of the power switching element (6) being controlled by the control pulses (Pct) to maintain the rectified output voltage (Vo) at a constant value. The overcurrent protection apparatus includes an overcurrent detector (CT, 7) which issues an overcurrent detection signal (OCD) after detecting that a current flowing into the power switching element (6) has exceeded a prescribed value; a memory circuit (12) set by the overcurrent signal (OCD); a gate circuit (13) for blocking the passage of control pulses (Pct) when the memory circuit (12) has been set; and a reset circuit (11) for resetting the memory circuit in response to the trailing edge of a control pulse (Pct). The switching of the power switching element (6) is controlled by the memory circuit (12), wherein the power switching element (6) is turned off when the memory circuit (12) has been set, and turned on when the memory circuit (12) has been reset.

Fig. 2

**0031986**

# OVERCURRENT PROTECTION APPARATUS

This invention relates to an overcurrent protection apparatus in a switching power supply, and more particularly to an overcurrent protection apparatus for protecting a power switching element from damage, which element is employed in a switching power supply.

A stabilized power supply of a continuously controlled type ordinarily invites losses in a control circuit and therefore is unsuitable for a stabilized power supply of the type that supplies high power. On the other hand, a switching power supply is not accompanied by large control circuit losses and for this reason is well-suited for application as a stabilized power supply of the type described.

A switching power supply generally includes a rectifier circuit for rectifying AC voltage, a transformer having a primary winding connected to the rectifier circuit and a secondary winding connected to a smoothing circuit, and a power switching element for opening and closing the primary side of the transformer, with DC voltage of a prescribed level being obtained from the output of the smoothing circuit by suitable switching control of the power switching element.

A power switching element in the switching power supplies of the aforesaid type is likely to be damaged if an excessive current flows into it. This damage to the power switching element owing to the inflow of excessive current occurs when the iron core of the transformer saturates, when a short-circuit occurs in the secondary wiring for some unforeseen reason, or when the associated circuitry is overloaded. It is therefore common practice in the conventional switching power supplies to provide the primary circuit with current detection means operable to detect the value of the primary current, in which the arrangement is such that an excessive primary current is not permitted to flow into the power switching element because the element is turned off when the primary current is detected as exceeding a predetermined value. However, an important drawback in this conventional overcurrent protection apparatus is a delay between detection of primary current and the opening of the power switching element. The delay is not a major factor as long as the increase in primary current defines a comparatively gentle curve, in which case the power switching element can be almost fully protected. The problem arises when the primary current increases abruptly due to an accident such as saturation of the transformer core or a short-circuit on the secondary side, in which case the delay mentioned above does not allow the power switching element to be protected until after the excessive current has begun to flow. The power switching element suffers damage as a result. A method of preventing such damage in the conventional overcurrent protection apparatus involves the use of a power switching element of a large current capacity, but the cost of these switching elements increases in proportion to their current capacity, and the amount of heat which is generated does not dissipate easily.

Another problem encountered in the conventional overcurrent protection apparatus involves the supply of the DC voltage. Once an overcurrent has been detected the power switching element is turned off to protect it and then, when the cause of the overcurrent has been eliminated, the switching of the element resumes in normal fashion so that the supply of the DC voltage can continue. However, the supply of the DC voltage also is terminated even if the primary current accidentally becomes excessive only for a brief instant and then returns to a normal value. This unnecessary interruption in DC voltage diminishes operating efficiency since it deprives the DC-powered equipment such as a numerical control equipment of its driving voltage and hence causes the equipment to cease operating. Moreover, although an excessive rush current generally flows into the primary circuitry when an AC power source is connected, it is necessary that the conventional overcurrent protection apparatus be designed so that it will not react to this rush current. Such a requirement complicates the circuitry and raises the cost.

A further difficulty in the prior-art apparatus involves the fact that there are occasions where the switching elements in a switching power supply are turned on for a longer period of time than they are turned off, which means that the energy stored in the inductance of the transformer when the switching elements are on is not completely released. The remaining energy gradually accumulates, causes the transformer to saturate, and leads to an excessive primary current. This in turn invites damage to the elements and an interruption in DC voltage.

According to the present invention there is provided overcurrent protection apparatus for protecting a power switching element, the switching of which power switching element, to interrupt an electric current delivering power, is controlled by switching control pulses, the apparatus comprising overcurrent detection means for issuing an overcurrent detection signal after detecting that an electric current flowing into the power switching element has exceeded a prescribed value, characterised in that the apparatus includes memory means set by the overcurrent detection signal, a gate circuit for turning off the power switching element by blocking the switching control pulses when said memory means has been set, and reset means for resetting said memory means in response to the trailing edge of a switching control pulse, wherein the power switching element is turned off when said memory means has been set, and subjected to switching control in accordance with the control pulses when said memory means has been reset.

An embodiment of the present invention provides overcurrent protection apparatus for example for use in a switching power supply, and more particularly overcurrent protection apparatus which, in spite of a malfunction such as a short-circuit, can prevent damage of a power element employed in a switching power supply while enabling a continuous supply of DC voltage.

In an embodiment of the present invention the destruction of a power switching element owing to flow of an excessive current therethrough can be prevented, this being accomplished by turning the power element off promptly, that is, without delay, as soon as the overcurrent condition is detected.

An embodiment of the present invention can provide overcurrent protection apparatus capable of supplying DC voltage even after the power switching element has been turned off by the detection of an overcurrent condition, this being accomplished by allowing the power switching element to be turned on and off continuously during the cycle that immediately follows the initial disabling of the element.

An embodiment of the present invention can provide overcurrent protection apparatus in a switching power supply, which is capable of continuing the supply of DC voltage in a normal manner despite the flow of instantaneous overcurrents.

Further, an embodiment of the present invention can provide overcurrent protection apparatus which is capable of preventing the flow of overcurrent owing to transformer saturation, this being accomplished by turning a power switching element off longer than it is turned on.

Apparatus embodying the present invention can be of a simple construction.

Reference will now be made, by way of example, to the accompanying drawings, in which:-

Fig. 1 is a block wiring diagram of a conventional overcurrent protection apparatus employed in a switching power supply;

Fig. 2 is a block wiring diagram of an overcurrent protection apparatus according to the present invention;

Fig. 3 is a waveform diagram associated with the block diagram of Fig. 2;

Fig. 4 is a diagram useful in describing another embodiment of the present invention; and

Fig. 5 is a block wiring diagram of another switching power source to which the present invention can be applied.

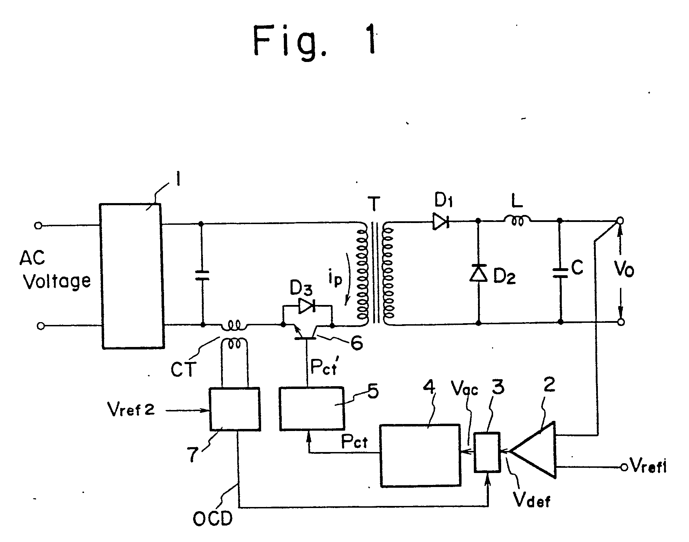

Illustrated in Fig. 1 is a block diagram that depicts one example of a conventional switching power supply, the system including a rectifier circuit 1, a

transformer T, diodes $D_1$, $D_2$, a choke L and capacitor C for smoothing, a diode $D_3$ for releasing the energy stored in transformer T, a differential amplifier 2 for comparing an output voltage $V_O$ with a reference voltage $V_{ref_1}$ and for producing a voltage $V_{def}$ indicative of the difference therebetween, an amplitude control circuit 3 for controlling the amplitude of the voltage $V_{def}$ provided by differential amplifier 2, a pulse width modulator 4 for generating a control pulse $P_{ct}$ whose width is modulated in accordance with a signal $V_{ac}$ provided by amplitude control circuit 3, a driver 5 for amplifying the weak control pulse $P_{ct}$ to turn on a power switching element, to be described hereinafter, when the control pulse $P_{ct}$ is present, and a switching element 6 which is switched in accordance with a driving pulse $P_{ct}'$ from driver 5 to deliver the DC power from rectifier 1 to rectifying and smoothing sections connected to the secondary side of transformer T. Pulse width modulator 4 is composed of circuitry which is not shown, such as a saw tooth generator for generating a saw tooth signal $V_{saw}$ of a fixed amplitude and frequency, and a comparator for comparing the amplitude of an output signal $V_{ac}$ from amplitude control circuit 3 with the amplitude of the saw tooth signal $V_{saw}$, the output of the comparator going to a logical "1" level to produce the control pulse $P_{ct}$ when $V_{saw}$ (amplitude) $\geq V_{ac}$ (amplitude).

There are three occasions on which an excessive current can flow into switching element 6 during the operation of the conventional switching power supplies of the type described. They are:

(1)   when the core of transformer T saturates;

(2)   when the diodes $D_1$, $D_2$ on the secondary side of the transformer are short-circuited; and

(3)   when the circuitry is overloaded.
This necessitates the provision of an overcurrent protection circuit.

One method of protecting the switching power supplies involves limiting the value of primary current $i_p$ to a fixed upper limit by regulating the pulse width of control pulse $P_{ct}$. The arrangement of Fig. 1 accomplishes this through a current regulating-type protection circuit the construction and operation of which will now be described.

Specifically, in Fig. 1, a current transformer CT is provided to detect the primary current $i_p$, and a comparator circuit 7 is connected to the current transformer CT, amplitude control circuit 3, and a reference voltage $V_{ref_2}$, the comparator 7 being adapted to compare a signal from current transformer CT with the reference voltage $V_{ref_2}$ that defines the limiting level of primary current $i_p$, and deliver to amplitude control circuit 3 an overcurrent signal OCD which is produced when the primary current $i_p$ exceeds the limiting level. Amplitude control circuit 3 responds to overcurrent signal OCD by suppressing the amplitude of the output voltage $V_{def}$ from differential amplifier 2 to a low level. Pulse width modulator 4 responds in turn by regulating the width of its output control pulse $P_{ct}$, whereby the value of primary current $i_p$ is prevented from exceeding a fixed upper limit.

0031986

In the above arrangement a signal applied to the input side of differential amplifier 2 must pass through or be acted upon by the differential amplifier, a phase compensating circuit which is usually inserted into the circuitry, the amplitude control circuit 3, the pulse width modulator 4, etc., before a signal can be obtained at the output side of the driver 5. The result is a delay in the initiation of the protecting operation. While this delay may not hamper almost full protection of the power switching element when an overload causes only a comparatively gentle increase in the primary current $i_p$, there are frequently cases where the delay does not allow the primary current to be limited early enough, as when the core of transformer T saturates or when a short-circuit develops on the secondary side of the transformer T to cause a sharp rather than a gentle increase in the primary current. In other words, when a control pulse $P_{ct}$ is generated the pulse width thereof is in general not subjected to suitable control because of the delay, but the pulse width of a subsequently generated control pulse will be regulated since the delay will have already elapsed, and this control pulse will function to limit the primary current $i_p$ to a value below the upper limit. This means that the overcurrent protecting operation is delayed by one control pulse. However, since power switching element 6 remains on because of the improperly regulated initial control pulse, and remains on until the initial control pulse vanishes, the switching element will be damaged if it is subjected to an excessive primary current $i_p$ having a steep rising edge while the element is conducting. Power switching elements of a large capacity therefore are adopted in the prior art in order to prevent such damage.

Conventional overcurrent protection circuits also are designed such that the power switching element is turned off once an overcurrent has been detected and then, when the cause of the overcurrent has been eliminated, the gating control of the element is resumed to supply the DC voltage. However, the supply of the DC voltage also is terminated even if the primary current becomes excessive only for an instant before returning to a normal value. Termination of the DC voltage supply in such a case is not desirable.

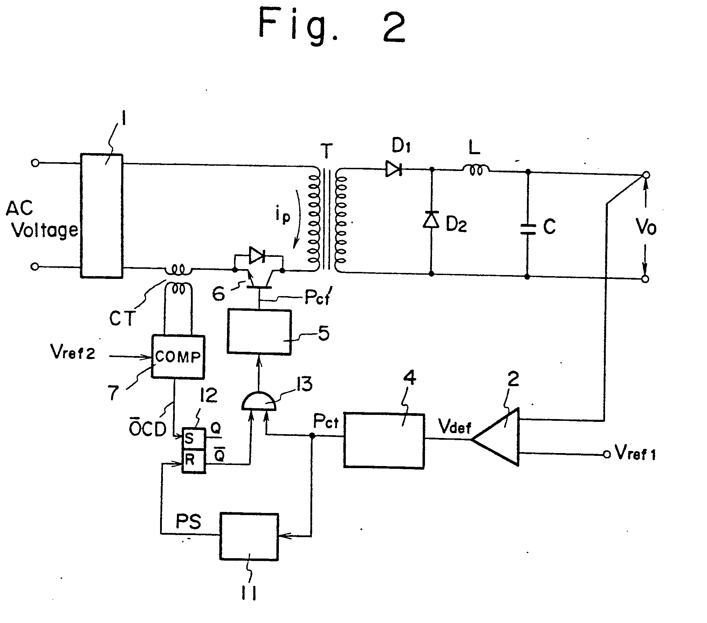

An embodiment of the present invention is shown in the circuit block diagram of Fig. 2. The illustrated arrangement includes the addition of a pulse generating circuit 11 which generates a pulse PS that resets a latch circuit, to be described hereinafter, in response to the trailing edge of the control pulse $P_{ct}$ produced by pulse width modulator 4, and which comprises a differentiating circuit; a latch circuit 12 comprising an RS-type flip-flop, the latch being set by output signal OCD from comparator circuit 7, and reset by output pulse PS from pulse generating circuit 11; and an AND gate 13 one input terminal of which receives the control pulse $P_{ct}$ from pulse width modulator 4, the other input terminal of which receives reset signal $\bar{Q}$ from latch circuit 12. Here, the pulse generating circuit 11, flip-flop 12, AND gate 13 and comparator 7 form an overcurrent protection circuit. Other portions in Fig. 2 that bear the same reference numerals as those in Fig. 1 are similar thereto and need not be described again here.

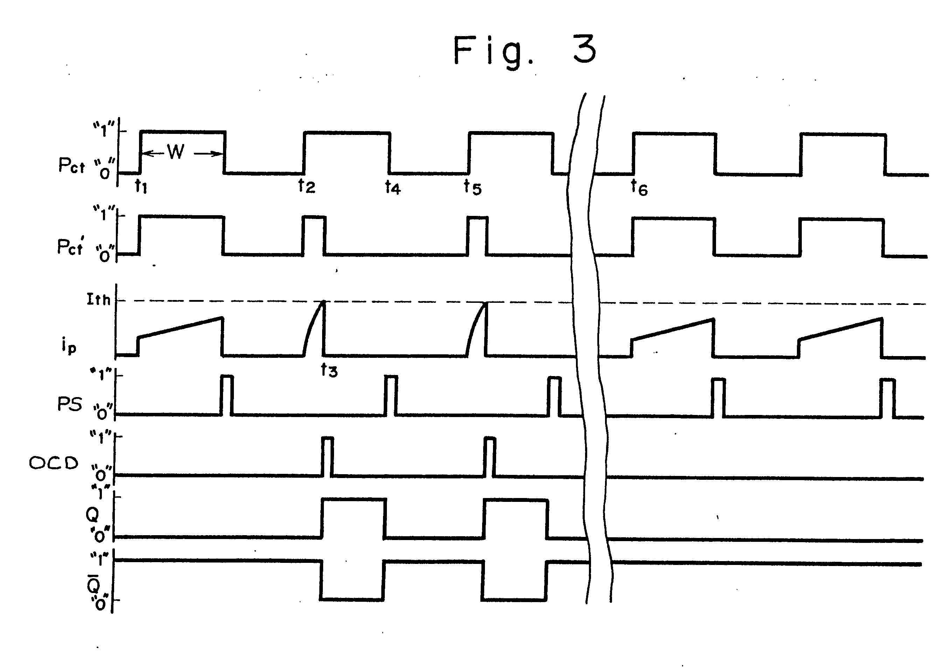

The operation of the present embodiment will now be described in connection with the waveforms of Fig. 3.

Differential amplifier 2 produces an output signal $V_{def}$ whose amplitude is based upon the difference in amplitude between the power supply output voltage $V_o$ and the reference voltage $V_{ref_1}$. Pulse width modulator 4 responds to output signal $V_{def}$ by producing, at time $t_1$ in Fig. 3, a control pulse $P_{ct}$ having a prescribed pulse width W. Under normal operating conditions, that is, under a condition where the circuitry continues to operate with the primary current $i_p$ being within the prescribed limit, latch circuit 12 is in the preset state and its reset output $\overline{Q}$ is at logical "1". As a result, AND gate 13 is opened so that a driving pulse $P_{ct}$, having the same pulse width as control pulse $P_{ct}$ appears at the output side of driver 5. The driving pulse turns switching element 6 on so that a primary current $i_p$, shown in Fig. 3, is allowed to flow through the primary side of transformer T. When control pulse $P_{ct}$ from pulse width amplifier 4 decays, pulse generating circuit 11 generates a pulse PS in conformance with the timing of this negative-going transition, and the pulse is applied to the reset terminal of latch circuit 12 which is in the reset state as mentioned above. The output $\overline{Q}$ of the latch therefore remains at logical "1".

Pulse width modulator 4 issues a second control pulse $P_{ct}$ at time $t_2$. If it is assumed that the secondary side of transformer T develops a short-circuit at this time for some unforeseen reason such as a metal filing falling across the secondary coil, the primary current $i_p$ will rise in an abrupt manner. This change is detected by current transformer CT. At time $t_3$, comparator circuit 7, comparing the output voltage from current transformer CT against reference voltage $V_{ref_2}$ which decides the prescribed upper limit $I_{th}$ of the primary current, issues the overcurrent signal OCD since the current transformer output at this time is of a value that causes the limit $I_{th}$ to be exceeded. Overcurrent signal OCD is applied to latch circuit 12 without delay and sets the latch so that its outputs $Q$, $\overline{Q}$ go to logic levels "1" and "0", respectively. AND gate 13 is closed at the instant latch circuit 12 is set and therefore interrupts the control pulse $P_{ct}$ from pulse width modulator 4 so that only a fraction of the pulse passes through the gate. Thus, when control pulse $P_{ct}$ is interrupted at time $t_3$, driving pulse $P'_{ct}$ from driver 5 goes to logical "0" so that power switching element 6 is turned off. When the power switching element is turned off it is obviously protected because the primary current $i_p$ which had started to rise so sharply is immediately reduced to zero. When the control pulse $P_{ct}$ from pulse width modulator 4 decays at time $t_4$, pulse generating circuit 11 again generates pulse PS in conformance with the timing of this negative-going transition, and the pulse PS is again applied to the reset terminal of latch circuit 12 which is in the set state because of the previous operation. However, the arrival of pulse PS reverses the state of the latch so that its outputs $Q$,

$\bar{Q}$ now go to logic levels "0" and "1", respectively. When the latch is reset in this manner, AND gate 13 is reopened.

If the secondary side of transformer T remains shorted by the metal filing as described above and pulse width modulator 5 delivers a third control pulse $P_{ct}$ at time $t_5$, the power switching element 6 remains protected by a repeat of the protecting operation just explained.

Let it now be assumed that the metal filing which has been the source of the short-circuit, and hence the reason for the foregoing repetitive protecting operation, is removed from across the secondary winding. If pulse width modulator 4 now generates a control pulse $P_{ct}$ at time $t_6$, the pulse will be passed by the open AND gate 13 and delivered to driver 5 which will respond by producing driving pulse $P_{ct}'$ that is applied to power switching element 6 to turn the switching element on. A normal primary current $i_p$ thereflows into the primary side of transformer T. Next, when the control pulse $P_{ct}$ from pulse width modulator 4 decays, pulse generating circuit 11 generates pulse PS in synchronism therewith, and the pulse is applied to the reset terminal of latch circuit 12. This represents normal operation which continues as long as the primary current does not exceed the limit $I_{th}$.

The protection of the power switching element in the foregoing embodiment proceeds in a similar manner to deal with increases in primary current resulting from overloading or from saturation of the transformer core. It should also be noted that the overcurrent signal OCD from comparator circuit 7 is temporarily retained in latch circuit 12 to preclude an oscillatory phenomenon which would occur if the signal OCD were sent directly from comparator circuit 7 to the input of AND gate 13. In other words, "latching" the signal OCD prevents the creation of a closed cycle in which the primary current $i_p$ increases, comparator 7 detects the overcurrent, AND gate 13 closes, the primary current $i_p$ decreases, comparator 7 detects the decrease in current, AND gate 13 opens, the primary current $i_p$ increases ... and so on.

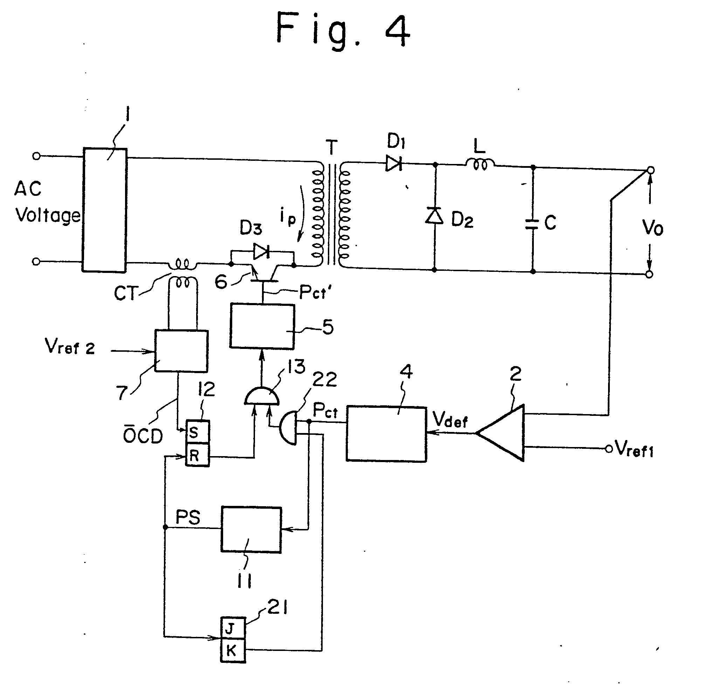

Another embodiment of the present invention is depicted in Fig. 4 wherein the embodiment of Fig. 2 is provided additionally with means which allows the switching element to turn on for a period of time which is shorter than the period of time the element is turned off. The additional means are a JK-type flip-flop 21 which is set and reset in repetitive fashion each time a pulse PS arrives from pulse generating circuit 11, and an AND gate 22 which passes a control pulse $P_{ct}$ when the JK-type flip-flop 21 is in the reset state. If it is assumed that JK-type flip-flop 21 initially is in the reset state, a first control pulse $P_{ct}$ will pass through AND gate 22, but a second such control pulse will be blocked by the AND gate 22 since JK-type flip-flop 21 will have been set by the initial control pulse via circuit 11. Thereafter, and in a similar manner, only odd-numbered control pulses $P_{ct}$ are allowed through AND gate 22; even-numbered control pulses are blocked. Thus, since only every other control pulse is applied to driver 5, power switching element 6 will, on the whole, be turned off longer than it is turned on even if the duty cycle of the control pulse $P_{ct}$ is greater than 50%.  This will allow the energy stored in transformer T to be released through diode $D_3$ in a reliable manner and therefore prevents saturation of transformer T.

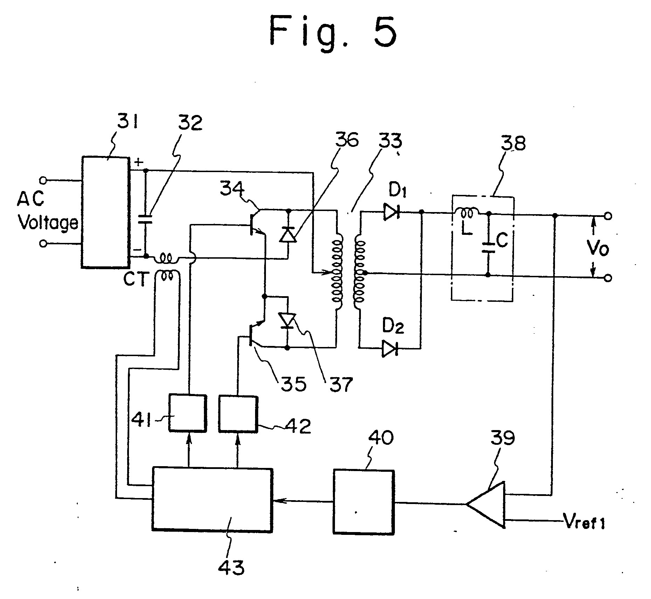

Fig. 5 shows another example of a switching power supply in which the present invention can be applied.  The arrangement of Fig. 5 includes a full-wave rectifier 31, a smoothing capacitor 32, a transformer 33 whose primary winding has its center tap connected to the plus side of the full-wave rectifier, power switching elements 34, 35 connected to respective ends of the primary winding, diodes 36, 37 through which the energy stored in transformer 33 is released when the corresponding power switching elements are off, rectifying diodes $D_1$, $D_2$, a capacitor C and choke L which construct a smoothing circuit 38, a current transformer CT for detecting primary current $i_p$, a differential amplifier 39, a pulse width modulator 40, drivers 41, 42 for driving the power switching elements, and an overcurrent protection circuit 43 which is similar to the arrangement of Fig. 2 except for the fact that the present circuit controls the switching of the two switching elements 34, 35 in an alternating manner.  Since the power switching elements 34, 35 in this switching power supply are opened and closed alternatingly, each switching element is off longer than it is on so that transformer saturation which accompanies an accumulation of energy is prevented.

In summary, the present invention as described above protects a power switching element through an arrangement in which a gate circuit is inserted between the output side of a pulse width modulator and the input side of a driving unit that supplies the power switching element with driving pulses, the gate circuit being closed by an overcurrent signal produced as a result of a detection operation by overcurrent detection means. The closure of the gate circuit immediately blocks the driving pulses applied to the switching element so that the protecting operation is not delayed by such circuitry as a phase compensating circuit and amplitude control inserted in the path between the input side of a differential amplifier and the output side of the pulse width modulator as in the prior art. The power switching element therefore is shut off immediately and hence protected as soon as an overcurrent flowing through the switching element exceeds a prescribed value. Moreover, since the gate circuit which has been closed as above can be opened automatically by a latch circuit when the latch is reset periodically by a signal from a trailing edge detecting means, it is not necessary to manually reset the switching power supply rendered inoperable by the occurrence of the overcurrent. Thus, normal operation of the circuitry can be restored automatically and immediately when the primary current returns to normal because of a normalization of load or the like.

It is to be noted that while the latch circuit is reset by the reset pulse from the training edge detecting means in the foregoing embodiments, the latch reset timing need not necessarily coincide with the trailing edge of the control pulse; it will suffice if this is achieved any time prior to the arrival of the next control
pulse.  It will therefore be understood that exactly the
same effect can be obtained if, by way of example, a
timer circuit is provided and adapted to issue a pulse
a set time after the leading edge of a control pulse
has been detected.

CLAIMS

1. Overcurrent protection apparatus for protecting a power switching element, the switching of which power switching element, to interrupt an electric current delivering power, is controlled by switching control pulses, the apparatus comprising overcurrent detection means for issuing an overcurrent detection signal after detecting that an electric current flowing into the power switching element has exceeded a prescribed value, characterised in that the apparatus includes memory means set by the overcurrent detection signal, a gate circuit for turning off the power switching element by blocking the switching control pulses when said memory means has been set, and reset means for resetting said memory means in response to the trailing edge of a switching control pulse, wherein the power switching element is turned off when said memory means has been set, and subjected to switching control in accordance with the control pulses when said memory means has been reset.

2. Apparatus as claimed in claim 1, wherein the power switching element is arranged for interrupting primary current of a transformer, and wherein the switching control pulses are generated by a control circuit operable to modulate the pulse width of those pulses in dependence upon variation in a rectified output voltage derived from the secondary side of the transformer, to control switching of the power switching element to maintain the rectified output voltage at a constant value.

3. Overcurrent protection apparatus according to claim 1 or 2, in which said reset means is composed of integrating circuitry.

4. Overcurrent protection apparatus according to claim 1 or 2, in which said reset means is composed of differentiating circuitry.

5. Overcurrent protection apparatus according to claim 1, 2, 3 or 4, in which the period of time for which the power switching element is normally off is longer than the period of time for which the power switching element is normally on.

6. Overcurrent protection apparatus according to claim 5, in which the power switching element is supplied with every other one of the control pulses.

1/5

# Fig. 1

# Fig. 2

# Fig. 3

3/5

0031986

# Fig. 4

## Fig. 5

# EUROPEAN SEARCH REPORT

**European Patent Office ·**

| DOCUMENTS CONSIDERED TO BE RELEVANT | | | CLASSIFICATION OF THE APPLICATION (Int. Cl.³) |
|---|---|---|---|
| Category | Citation of document with indication, where appropriate, of relevant passages | Relevant to claim | |
| X | <u>US - A - 3 930 194</u> (L.H. WALKER)<br><br>* complete document *<br><br>-- | 1-6 | H 02 M   1/18<br>H 02 H   7/122 |
| | <u>US - A - 4 070 701</u> (J.D. HARNDEN, JR. et al.)<br><br>* column 9, line 23 and following; fig. 8 *<br><br>-- | 1-6 | |
| | VALVO TECHNISCHE INFORMATIONEN FÜR DIE INDUSTRIE, No. 770415, April 1977 Hamburg "Steuer- und Regelschaltung TDA1060 für Schaltnetzteile" pages 1 to 7 * page 6, paragraph 2.5; fig. 12 *<br><br>-- | 1-6 | **TECHNICAL FIELDS SEARCHED (Int.Cl.³)**<br><br>H 02 H   7/00<br>H 02 M   1/18<br>H 02 P   13/22 |
| A | <u>DE -B2 - 2 416 985</u> (SIEMENS AG)<br><br>---- | | |

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

| X | The present search report has been drawn up for all claims | | |
|---|---|---|---|
| Place of search | Date of completion of the search | Examiner | |
| Berlin | 05-09-1980 | GESSNER | |

EPO Form 1503.1   06.78